# EUROPEAN PATENT SPECIFICATION

(11) **EP 1 382 125 B1**
(45) Date of publication and mention of the grant of the patent: **09.11.2005**
(21) Application number: 02720385.0
(22) Date of filing: 09.04.2002
(51) Int. Cl.: H03M 13/17, G06F 11/10, G11B 20/12, G11B 20/18

(54) **METHOD AND DEVICE FOR ENCODING INFORMATION WORDS, METHOD AND DEVICE FOR DECODING INFORMATION WORDS, STORAGE MEDIUM AND SIGNAL**
VERFAHREN UND GERÄT ZUR INFORMATIONSCODIERUNG, VERFAHREN UND GERÄT ZUR INFORMATIONSDECODIERUNG, SPEICHERMEDIUM UND SIGNAL
PROCEDE ET DISPOSITIF DE CODAGE DE MOTS D'INFORMATION, PROCEDE ET DISPOSITIF DE DECODAGE DE MOTS D'INFORMATION, SUPPORT DE STOCKAGE ET SIGNAL

(30) Priority: 19.04.2001 EP 01201416
(43) Date of publication of application: 21.01.2004
(73) Proprietor: Koninklijke Philips Electronics N.V., 5621 BA Eindhoven (NL)
(72) Inventor: COENE, Willem, M., J., M., NL-5656 AA Eindhoven (NL); VAN DIJK, Marten, E., NL-5656 AA Eindhoven (NL); BAGGEN, Constant, P., M., J., NL-5656 AA Eindhoven (NL)
(74) Representative: Deguelle, Wilhelmus H. G.
(86) International application number: PCT/IB2002/001295
(87) International publication number: WO 2002/087090

(56) References cited:
- EP-A- 0 364 229
- EP-A- 0 729 150
- NARAHARA T ET AL: "OPTICAL DISC SYSTEM FOR DIGITAL VIDEO RECORDING" , JAPANESE JOURNAL OF APPLIED PHYSICS, PUBLICATION OFFICE JAPANESE JOURNAL OF APPLIED PHYSICS. TOKYO, JP, VOL. 39, NR. 2B, PART 1, PAGE(S) 912-919 XP001005912 ISSN: 0021-4922 paragraph [0004]
- SCHEP K ET AL: "FORMAT DESCRIPTION AND EVALUATION OF THE 22.5 GB DIGITAL-VIDEO-RECORDING DISC" JAPANESE JOURNAL OF APPLIED PHYSICS, PUBLICATION OFFICE JAPANESE JOURNAL OF APPLIED PHYSICS. TOKYO, JP, vol. 40, no. 3B, PART 1, 5 September 2000 (2000-09-05), pages 1813-1816, XP001038396 ISSN: 0021-4922

## Description

The invention relates to a method for encoding information words comprising the steps of encoding said information words into an error correction code comprisingerror correction code words, encoding said error correction code words into a modulation code comprising channel words, thereby using a burst-indicator subcode capable of indicating burst errors, said burst-indicator subcode comprising burst-indicator subcode bytes including a number of burst indicator subcode bits.

Furthermore, the invention relates to a method for decoding information words comprising the steps of decoding a modulation code comprising channel words in order to achieve error correction code words of an error correction code, decoding said error correction code words in order to achieve said information, thereby using a burst-indicator subcode for indicating burst errors, said burst indicator subcode comprising burst-indicator subcode bytes including a number of burst-indicator subcode bits.

Furthermore, the invention relates to a device for thus encoding information words according to the preamble of claim 15.

Furthermore, the invention relates to a device for thus decoding information words according to the preamble of claim 16.

Furthermore, the invention relates to a storage medium storing thus encoded information and a signal comprising a stream of channel words containing thus encoded information words.

In the field of optical recording an optical disc system comprises an error correction code (ECC) process and a modulation process to encode ECC code words.

For example, for the practical case of DVR the ECC process uses an error correction code of the format of a long-distance ECC code (LDC) in combination with a burst-indicator subcode (BIS). The LDC code consists of a [248, 216, 33] Reed-Solomon Code. The BIS code consists of a [62, 30, 33] Reed-Solomon Code. The BIS-code-carries address and control information and is very strongly protected, so that with extremely high probability the BIS code can be properly decoded, i.e., all of its errors can be corrected.

The reason for this kind of coding is that in the field of DVR the spot size of a laser spot on the entrance surface of a DVR disc is reduced from approximately 0.50 mm diameter for DVD discs to 0.14 mm diameter. This results in increased sensitivity to dust and scratches on the disc surface, which may cause burst errors, on top of the usual random errors during read out of the recording layer. The above-mentioned ECC code uses two correction mechanisms to handle these errors effectively, namely the LDC combined with the BIS.

A location of corrected bytes of the BIS code and a location of SYNC-patterns that are in error are used as so-called pickets indicating the position of likely long burst errors in the LDC data between these pickets. When subsequent pickets are erroneous, it is highly likely that all the data located physically in between these pickets was also detected erroneously. The LDC can use this information to perform erasure correction. Thereby, the BIS-bytes are encoded with a modulation code in the modulation process that is the same modulation code as for the LDC bytes.

Such an optical disc system is disclosed in the article "Optical Disc System for Digital Video Recording", Proceedings ISOM/ODS, Hawai, 1999, SPIE Vol. 3864, pp. 50-52 T. Narahara, S. Kobayashi, M. Hattori, Y. Shimpuku, G. van den Enden, J. Kahlman, M. van Dijk, R. van Woudenberg, as well as in T. Narahara et al. "Optical disc system for digital video recording", Japanese Journal of Applied Physics, Tokyo, JP.Vol 39, Nr. 2B, Part 1, pp. 912-919.

Further BIS systems are disclosed in WO 00/07300 and WO 99/34271.

However, there are still burst errors that are not detected by this known system, since they are located between two pickets without effecting both adjacent pickets. Furthermore, the tails of long burst errors are also not detected by this prior art system.

It is therefore an object of the invention to improve burst error detection.

This object is achieved by providing a method for encoding information according to the above-mentioned type characterized by encoding the burst indicator subcode bits of each burst-indicator subcode byte into different channel words.

The object is further achieved by providing a method for decoding information according to the above-mentioned type being characterized by decoding the burst-indicator subcode bits from different channel words.

The object is further achieved by providing a device for encoding information according to claim 15.

The object is further achieved by providing a device for decoding information according to claim 16.

The object is further achieved by providing a storage medium storing encoded information being encoded according to claim 17.

Furthermore, the object is achieved by providing a signal comprising a stream of channel words containing encoded information words, in particular for use in internet applications, e.g. for applications transmitting information without the need of a storage medium.

The invention enables spreading the burst-indicator subcode bits over an entire frame of channel words. A frame is typically a group of channel words preceded by synchronization pattern. Whereas in known systems the BIS-bits are grouped into 3 bytes, according to the invention a fine rake - much more sensible to burst errors than a much coarser rake of a number of (3) BIS-bytes according to the prior art - of a large number of isolated BIS-bits for the detection of burst error events is provided.

Thus, the detection of burst errors is improved. As a result the error correction code properties can be improved as well.

Preferably, the BIS-bits are encoded into a particular characteristic property of different channel words, in particular in the parities of the channel words, in particular in the words that are encoded with a substitution code of the modulation code. Such combination of a main code and a substitution code is known as a combi code.

Preferably, the substitution code uses two possible channel words having opposite parity and a same next-state in an underlying finite-state machine. Thus, a DC-control of a signal containing the channel words can be established in a simple manner and particularly without adding a lot of redundancy, and thus keeping the code rate high.

Furthermore, it is preferred to encode the error correction code words in channel words by means of a main code of the modulation code, the substitution code, or the substitution code having a burst-indicator subcode bit encoded in the parities of the channel words. It should be noted that the information of the BIS bits can be encoded either in the parity of the channel words used for the substitution code or in the order in which the channel words of the substitution code appear in the code table of the substitution code. Thus, a high code rate can be obtained, thereby preserving high error correction properties and low or no DC-content in the channel signal.

Preferably, the BIS-bits are spread over an entire frame of channel words. Thus, burst error indication is enabled substantially over an entire frame and thus over an entire data block or data cluster. This spreading allows to detect even short burst errors and thus improves the error correction properties of the coding system.

Furthermore, it is preferred to assign erasures for the error correction code decoding based on detected erroneous BIS-bits. Thus, it is possible to eliminate burst errors with high reliability.

Furthermore, it is preferred to use a variable length code as the modulation code, such as a 17PP code which has a high coding efficiency.

These and other aspects of the invention will be apparent from and elucidated with reference to the embodiments described hereinafter with reference to the accompanying drawings, in which:
Fig. 1 shows a schematical diagram of a DVR system with ECC encoder, channel encoder, storage medium, channel decoder and ECC decoder,
Fig. 2 shows a known ECC structure of a 64 Kbyte physical cluster with burst-indicator subcode columns;
Fig. 3 shows a frame format for 152 bytes with inclusion of 24 burst-indicator subcode bits via the parity channel of a substitution code according to a preferred embodiment of the invention; and
Fig. 4 shows a diagram illustrating the ECC performance of burst-indicator subcode-code for the prior art DVR proposal in comparison with a EFMCC proposal according to an embodiment of the invention.

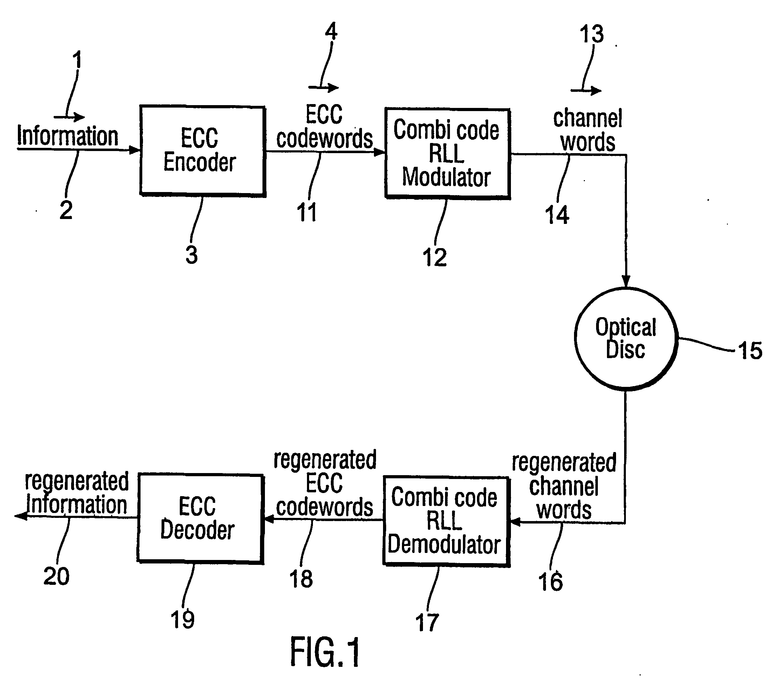

Figure 1 shows the principle structure of a DVR system. An information bit stream 1 is set via a signal line 2 to a ECC encoder 3. The ECC encoder 3 applies error-correction coding on the information bit stream 1 thereby generating ECC code words 4.

The ECC encoder 3 preferably uses a long-distance ECC code (LDC) such as a Reed-Solomon Code. The codes are designed such that most occurring combinations of random byte errors and burst errors can be corrected. Random byte errors are among others due to jitter causing a demodulator to output erroneous bytes. Bursts of errors are due to e.g. dust, finger prints, scratches, etc..

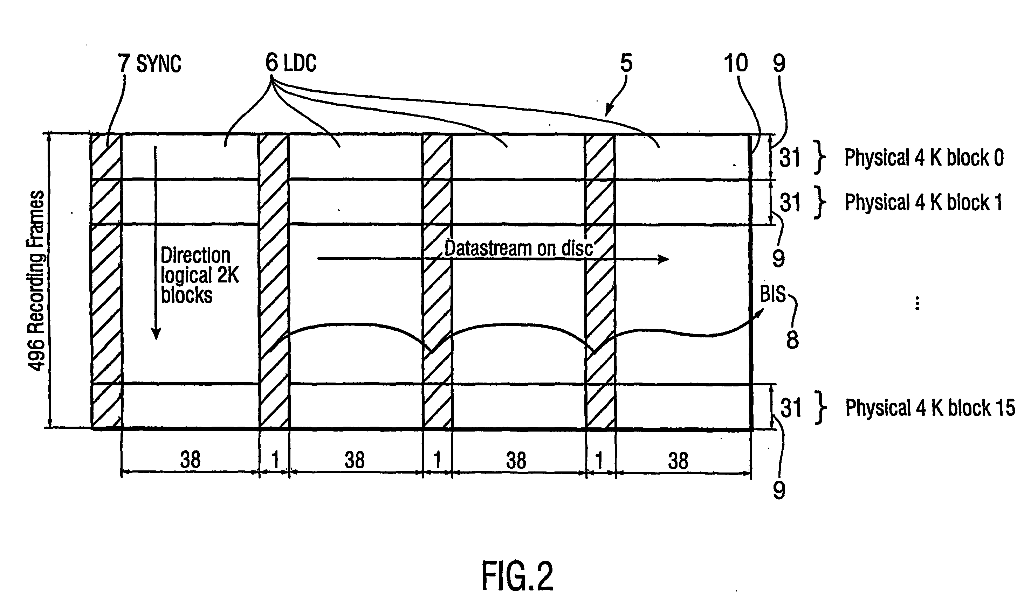

Figure 2 shows a commonly used ECC structure for DVR. This code uses two correction mechanisms, namely a long-distance code (LDC) combined with a burst-indicator subcode (BIS).

The long-distance code consists of 304 [248, 216,33] Reed-Solomon code words per cluster 5. A logical 2 Kbyte information block is arranged in 9.5 Reed-Solomon code words in addition with four additional bytes used for extra error detection. The LDC is designed such that it has sufficient parity symbols and interleaving lengths for correcting random errors, multiple long bursts and short bursts of errors. The burst error correction capability can be enhanced by using erasure correction on symbols that are indicated as being erroneous by a BIS code.

Bytes 6 of LDC are multiplexed with synchronization patterns 7 and bytes 8 of the burst-indicator subcode.

The burst-indicator subcode has 24 [62, 30, 33] Reed-Solomon-code words and carries address and control information. Due to the high distance of the [62, 30, 33] Reed-Solomon code which results in a low code rate, the code words of the burst-indicator subcode are strongly protected against errors, Therefore, the burst-indicator subcode can be properly decoded with a very high probability.

The location of its corrected bytes and erroneous synchronization patterns serve as "pickets" indicating the likely position of long burst errors in the LDC data between these pickets. It is assumed, that in case that subsequent pickets have been detected as erroneous, that all data located physically in between these pickets are also detected erroneously. In such a case the long-distance code can use this information to perform erasure correction.

Erasures are allocated to bytes that are most probable in error because they are part of an assumed burst of errors. The burst of errors is indicated by a certain strategy, based on BIS-bits (or BIS-bytes) that are in error. Therefore, a strong error correction code is applied on the information of the BIS-bytes, so that the BIS-bytes can be decoded free of any error.

A physical cluster 5 consists of 64 Kbyte user data organized in 16 physical 4 Kbytes blocks 9. Each block 9 is again subdivided into 31 recording frames 10. If it is desired to obtain the user data of one logical 2 Kbytes block it is only necessary to decode the burst-indicator subcode having all address information together with the corresponding 10 Reed-Solomon code words in the LDC 6. As it is not necessary to fully decode a 64 Kbyte LDC cluster 5 quick access to a logical 2 Kbyte block is enabled.

Referring back to Figure 1 such ECC code words 4 are transmitted via a signal line 11 to a channel modulator/encoder 12.

In particular a channel code generated by the channel modulator 12 is designed based on the principles of combi codes. Furthermore, the channel code can be designed with EFM (Eight-To-Fourteen-Modulation)-like RLL (Run Lengths Limited) constraints (d=2, k=10). RLL sequences have a minimum run length of d + 1 channel bits and a maximum run length of k + 1 channel bits. These codes used for optical recording are DC-free, i.e. they have almost no content at low frequencies. The DC-free property is needed in order to separate the information signal from low-frequency disc noise, which is needed in order to control the slicer level, which is the basis for the timing recovery and in order to avoid interference of the information signal with servo systems. The DC-control of the RLL sequences is performed via control of a Running Digital Sum (RDS). The RDS is the integral of the bipolar channel bit stream up to a given bit position. Such a code is known as EFMCC. This code is a combination code, that is based on a combination of two channel codes C1 and C2, which both operate on a byte-by-byte basis. Both codes are constructed based on a FSM (Finite State Machine) consisting of a predetermined number, preferably of 6 states.

Further details of such codes are described in W.M.J. Coene, E. Chuang, "EFMCC: a new combi-code for high-density optical recording", Proceedings of the SPIE, Optical Data Storage 2000 (Whistler, Canada), Volume 4090, pp. 275-282 and W.MJ. Coene, "Combi-Codes for DC-Free Runlength Limited Coding", IEEE Transactions on Consumer Electronics, Nov. 2000, Vol. 46, Nr. 4, pp. 1082-108.

Code C1 is called the main code, and maps a byte into a 15-bit channel word. Thereby a high coding rate is realized. Code C2 is called the substitution code, and maps a byte into one out of two possible 17-bit channel words. The goal of the code C2 is to achieve a guaranteed DC-control.

Both 17-bit channel words of the substitution code C2 satisfy the following two conditions for each of the coding states of the FSM. The first condition is that both channel words have opposite parity. The second condition is that both channel words have the same next-state in the FSM.

The EFMCC coding for a given format is based on an alternation scheme that defines the order in which the main code C1 and the substitution code C2 will be used for encoding of ECC code words 4.

The data encoded by the channel modulator 12 are output as channel words 13 via an electrical line 14 in order to be recorded on a storage medium 15, such as a DVR disc.

The code words 4 encoded with the substitution code C2 are the points in the channel bit stream 13 that allow for control of the DC-content. The parity selection at the substitution code C2 determines the polarity of the channel bit stream 13 for the subsequent code words all encoded with the main code C1, up to the next code word encoded with the substitution code C2.

The substitution code C2 of the EFMCC is in fact a parity-check code. Thus, the parity of the channel words can be controlled.

The channel words 13 stored on the storage medium 15 can be read by a reading device regenerating the channel words and passing them via a signal line 16 to a channel demodulator or channel decoder 17 being matched to the channel modulator or channel encoder 12.

The channel demodulator 17 regenerates the ECC code words and transmits the regenerated ECC code words via a signal line 18 to a ECC decoder 19 that regenerates the original information 1 and outputs this regenerated information to an output 20.

It is proposed to encode the bits of the BIS-bytes 8 (Figure 2) into a separate channel on top of the RLL channel. This separate channel is the parity channel that can be associated with the encoding of LDC bytes 6 with the substitution code C2 of the EFMCC. The idea is to use the parity selection of the substitution code C2 to accommodate a BIS-bit for burst-indication. Preferably, three BIS-bytes, i.e. 24 BIS-bits are needed for a single frame in the DVR format.

As a result three classes of LDC bytes 6 are provided:
A first class of LDC bytes 6 encoded with the main code C1 of EFMCC is provided.
A second class of LDC bytes encoded with the substitution code C2 of EFMCC, in view of DC-control is provided.
A third class of LDC bytes encoded with the substitution code C2 of EFMCC is provided with the accommodation of a BIS-bit in the parity of the corresponding 17-bit channel word of the substitution code. Alternatively, the BIS-bit can be encoded in the use of either the first or the second channel word that are present as entries in the coding table of the substitution code C2.

In the third class, the 17-bit channel word represents 9 bits of information, i.e. 8 bits corresponding to the LDC byte and an additional bit, the parity bit of the channel word, corresponding to the BIS-bit.

Thus, it is possible to spread individual BIS-bits over an entire frame 10, whereas in the prior art proposal the BIS-bits are grouped into three bytes. Therefore, according to the invention a fine rake of 24 isolated BIS-bits for the detection of burst errors is provided. In contrast to this, the known coding scheme has a much coarser rake of 3 BIS-bytes, as shown in Figure 2.

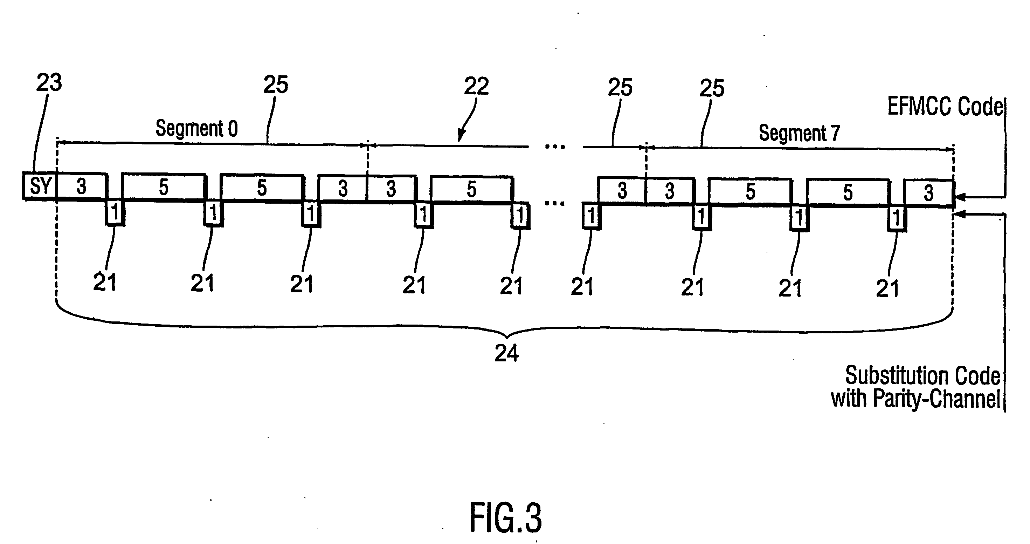

Figure 3 shows a symmetrical dispersion of 24 BIS-bits 21 over a frame 22 comprising a sync-pattern 23 and 152 LDC bytes 24, according to a preferred embodiment of the invention.

Each frame 22 is divided into eight segments 25. Each segment 25 comprises 19 bytes having the following structure:
3B 1S 5B 1S 5B 1S 3B.
This structure is repeated eight times in a frame 22. The bytes denoted by B are encoded with EFMCC, namely either with the main code C1 or the substitution code C2. The bytes denoted by S are encoded with the substitution code C2 of EFMCC in order to accommodate the BIS-bits. Each segment 22 contains three BIS-bits, thus in total yielding 24 BIS-bits or 3 BIS-bytes for an entire frame 22.
This structure can be expressed in more general terms as:
number of bytes with the structure
x₁B 1S x₂B 1S x₃B 1S...Xₙ₋₁ B 1S xₙB 1S xₙ₊₁B
with the condition that x₁, x₂, x₃, ..., xₙ₋₁, xₙ, xₙ₊₁ are integer values and 2ₓ₁, x₂, ...., xₙ₋₁, xₙ, 2xₙ₊₁ are as close as possible to each other and wherein B denotes a byte encoded with said main code C1 or substitution code C2 without a burst-indicator subcode bit and S denotes a byte encoded with said substitution code C2 having a burst-indicator subcode bit.

As a result a fine rake of 24 pickets, namely the bytes B containing the 24 BIS-bits for indication of the location of burst errors is constituted. This location information can be used for the above-mentioned erasure strategy of the LDC code.

In each segment 25 the 3 BIS-bytes 21 are encoded with a rate R = 1/2 because the channel words 13 of the substitution code C2 of EFMCC are two bits longer than the channel words of the main code C1 of EFMCC. According to the prior art they have been encoded via the main code C1 of EFMCC with a rate R = 8/15. Thus, encoding of the 3 BIS-bytes 21 requires an extra overhead of 3 channel bits for one recording frame. However, as a frame length is about 2400 channel bits, this implies a relative overhead of only 1 promille.

The idea of encoding the bits of BIS-bytes into a separate channel on top of the RLL channel is in principle applicable to any code in which there is a possibility to perform a parity check on fixed locations in the channel bit stream over a fixed or known number of channel bits. According to the above described embodiment this is possible by the locations of the bytes intentionally encoded with the substitution code for the parity channel.

For rewritable discs a different format of channel modulation maybe used, namely the so-called 17PP modulation code. The 17PP modulation code is a run length-limited (RLL) code based on (dk) sequences. The 17PP modulation code has run length constraints d = 1, k = 7. The DC-control is performed via the parity-preserving property of this code. This property implies that the parity of a code word and the parity of the corresponding channel word are equal. Further details of such code are described in US 5,477,222 and WO 99/63671.

The 17PP code is a variable-length synchronous code of rate R = 2/3, in which a data word can have a length of 2; 4, 6 or 8 data bits and a corresponding channel word has a length of 3, 6, 9 or 12 channel bits.

The parity of parts of the (dk) channel bit stream can be controlled in a guaranteed way by multiplexing single DC-control bits in the data bit stream: changing a DC-bit from 0 to 1 changes the parity accordingly. Parity changes in the (dk) bit stream lead to polarity changes in the bipolar channel bit stream, and these are used to limit the value of the running digital sum RDS.

In the following it is explained how the above-mentioned approach of encoding the bits of the BIS-bytes into a separate channel on top of the RLL channel is adopted for the 17PP code for the rewritable format of DVR.

As the 17PP code is a variable length code based on 2, 4, 6 or 8 consecutive data bits and the parity-preserve property holds for the corresponding 3, 6, 9 or 12 channel bits the 17 PP code is parity-preserving in successive coding windows of variable-size. This makes it impossible to derive the BIS-bits directly from the observation of the parity of a priori well defined parts of the channel bit stream. Therefore, it is proposed to perform detection of BIS-bits in the data bit stream, after a complete decoding of the channel bit stream. Thus, the idea of the invention is applicable to 17PP channel codes as well.

Two changes have to be performed compared to the prior art scheme using BIS bytes instead of BIS bits: A first change is the detection of the BIS-bits. When the combi code scheme is used, no RLL decoding is needed, only the detection of the parity of the channel words that accommodate the BIS-bits has to be carried out. A second change is that the erasure strategy of the ECC decoding has to be adapted.

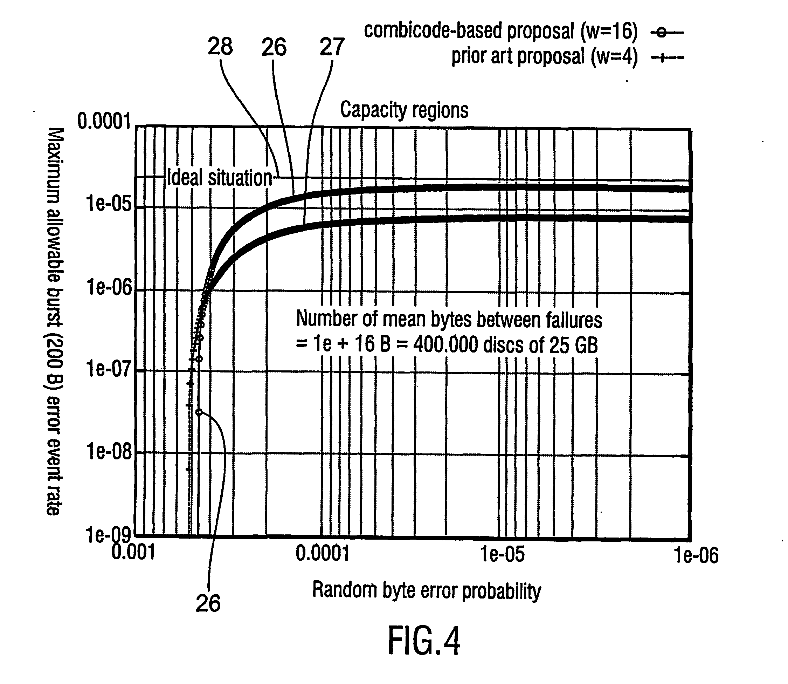

Figure 4 shows a diagram of the error correction code performance of the prior art BIS code in comparison with the combi code based proposal according to the invention. The horizontal axis indicates the random byte error probability before ECC decoding, whereas the vertical axis indicates the maximum allowable burst error event rate before ECC decoding.

Assumed that w is a parameter, called the window size, erasure strategies are considered in which all main bytes between two picket bytes/bits are erased if the two picket bytes/bits are close enough to one another, i.e. they are separated by at most w - 2 picket bytes/bits, and if both are corrupted by errors that are detected during the BIS decoding.

Further, a fixed number of mean bytes between failures after ECC decoding and a fixed burst length of a burst error to be investigated is assumed. Then curve 26 indicates the curve of the combi code based proposal and curve 27 indicates the prior art proposal. The area below the curves 26, 27 indicates the capacity regions, that are defined as follows: any point below the curve leads to an acceptable number of mean bytes between failures after ECC decoding. The combi code based proposal approaches the ideal situation for small random byte error probabilities indicated by line 28 according to which the decoder is assumed to know the precise location of all bytes of a burst event. Compared to the prior art proposal according to curve 27 the combi code based proposal according to curve 26 is a factor of approximately 2.5 better for small random byte error probabilities.

In the prior art proposal a window size w = 2 already achieves the depicted capacity region and in the combi code based proposal a window size w = 8 already achieves the depicted capacity region. In general for all considered situations, w = 2 suffices for the prior art proposal and w = 8 suffices for the combi code based proposal according to the invention.

Summarized, the idea of encoding bits of a burst-indicator subcode into a separate channel on top of the RLL channel, in particular in the parity of channel words of the substitution code of combi code, thus enabling spreading the BIS-bits over an entire frame, provides a "fine-rake" burst-indicator subcode with improved error detecting and correcting properties.

## Claims

1. A method for encoding information words (1) comprising the steps of
- encoding said information words (1) into an error correction code comprising error correction code words (4),
- encoding said error correction code words (4) into a modulation code comprising channel words (13),
- thereby using a burst-indicator subcode (8, 21) capable of indicating burst errors, said burst-indicator subcode (8, 21) comprising burst-indicator subcode bytes including a number of burst indicator subcode bits
**characterized by**
- encoding said burst-indicator subcode bits of each burst-indicator subcode byte into different channel words (13).

2. A method according to claim 1, **characterized by** encoding said burst-indicator subcode bits into a particular characteristic property of different channel words, in particular in the parities of said different channel words (13).

3. A method according to claim 1 or 2, **characterized by** encoding each of said burst-indicator subcode bits in the parities of said channel words (13) of a substitution code of said modulation code.

4. A method according to claim 3, **characterized by** said substitution code providing two possible channel words having opposite parity and a same next-state in a underlying finite-state machine.

5. A method according to claim 3, **characterized by** encoding said error correction code words (4) in channel words (13) with
a) a main code of said modulation code,
b) said substitution code of said modulation code, or
c) said substitution code of said modulation code having a burst-indicator subcode bit encoded in said parities of said channel words (13).

6. A method according to claim 1, **characterized by** spreading the burst-indicator subcode bits of a number of burst-indicator subcode bytes over an entire frame (22) of channel words (13).

7. A method according to claim 5 or 6, **characterized in that** said frame (22) comprises a number of segments (25), each segment (25) comprising a number of bytes with the structure
x₁B 1S x₂ B 1S x₃B 1S ... xₙ₋₁ B 1S xₙB 1S xₙ₊₁B
with the condition that x₁, x₂, x₃, ..., xₙ₋₁, xₙ, Xₙ₊₁ are integer values and 2ₓ₁, x₂, ...., xₙ₋₁, xₙ, 2xₙ₊₁ are as close as possible to each other and wherein B denotes a byte encoded with said main code or substitution code without a burst-indicator subcode bit and S denotes a byte encoded with said substitution code having a burst-indicator subcode bit.

8. A method according to claim 7, **characterized in that** x₁₊ᵢ is equal to 3, x₂₊ᵢ is equal to 5 and x₃₊ᵢ is equal to 5 and x₄₊ᵢ is equal to 3, with i being the index of the segments whereby i = 0,1,2,3, .....,7, the number of bytes of each segment is 19, each segment containing 3 burst-indicator subcode bits and each frame containing 24 burst-indicator subcode bits or 3 burst-indicator subcode bytes.

9. A method according to claim 1, **characterized in that** said modulation code is a variable length code.

10. A method according to claim 9, **characterized in that** said variable length code is a (1, 7) run length limited parity-preserve code.

11. A method for decoding information words (1) comprising the steps of
- decoding a modulation code comprising channel words (13) in order to achieve error correction code words (4) of an error correction code,
- decoding said error correction code words (4) in order to achieve said information (1),
- thereby using a burst-indicator subcode (8, 21) for indicating burst errors, said burst indicator subcode (8, 21) comprising burst-indicator subcode bytes including a number of burst-indicator subcode bits,
**characterized by**
- decoding said burst-indicator subcode bits from different channel words (13).

12. A method according to claim 11, **characterized by** decoding said burst-indicator bits from the parities of said channel words (13).

13. A method according to claim 11 or 12, **characterized by** assigning erasures for the error correction code decoding based on detected erroneous burst-indicator subcode bits in order to correct burst errors.

14. A method according to claim 11,12 or 13, **characterized by** decoding information being encoded according to any of claims 1 to 10.

15. A method according to claim 11, in which an erasure strategy is based on window size w of successive burst indicator subcode bits, allocating the erasure if or on condition that two successive erroneous burst indicator subcode bits are not more than w-2 locations away from each other.

16. A device for encoding information words (1) comprising
- information encoding means (3) for encoding information words (1) into an error correction code comprising error correction code words (4),
- code word encoding means (12) for encoding error correction code words (4) into a modulation code comprising channel words (13),
- thereby using a burst-indicator subcode (8, 21) capable of indicating burst errors, said burst-indicator subcode comprising burst-indicator subcode bytes including a number of burst-indicator subcode bits,
**characterized in that**
- said code word encoding means (12) encoding said burst-indicator subcode bits of each burst-indicator subcode byte into different channel words (13).

17. A device for decoding information words (1) comprising
- code word decoding means (17) for decoding a modulation code comprising channel words (16) in order to achieve error correction code words (18) of an error correction code,
- information decoding means (19) for decoding said error correction code words (18) in order to achieve said information (1),
- thereby using a burst-indicator subcode (8, 21) for indicating burst errors, said burst-indicator subcode (8, 21) comprising burst-indicator subcodes bytes including a number of burst-indicator subcode bits,
**characterized in that**
- said code word decoding means (17) decoding said burst-indicator subcode bits from different channel words (13).

18. A storage medium storing encoded information words (1) being encoded according to a method of any of claims 1 to 10.

19. A signal comprising a stream of channel words (13) containing encoded information words (1) being encoded according to a method of any of claims 1 to 10.

## Patentansprüche

1. Verfahren zum Codieren von Informationswörtern (1), wobei dieses Verfahren die nachfolgenden Verfahrensschritte umfasst:
- Codierung der genannten Informationswörter (1) zu einem Fehlerkorrekturcode mit Fehlerkorrekturcodewörtern (4),
- Codierung der genannten Fehlerkorrekturcodewörter (4) zu einem Modulationscode mit Kanalwörtern (13),
wobei ein Burst-Indikatorsubcode (8, 21) verwendet wird, der imstande ist, Burstfehler anzugeben, wobei der genannte Burst-Indikatorsubcode (8, 21) Burst-Indikatorsubcodebytes aufweist, die eine Anzahl Burst-Indikatorsubcodebits enthält,
**gekennzeichnet durch**
- Codierung der genannten Burst-Indikatorsubcodebits jedes Burst-Indikatorsubcodebytes zu verschiedenen Kanalwörtern (13).

2. Verfahren nach Anspruch 1, **gekennzeichnet durch** Codierung der genannten Burst-Indikatorsubcodebits zu einer bestimmten charakteristischen Eigenschaft verschiedener Kanalwörter, insbesondere in den Paritäten der genannten verschiedenen Kanalwörter (13).

3. Verfahren nach Anspruch 1 oder 2, **gekennzeichnet durch** Codierung jedes der genannten Burst-Indikatorsubcodebits in den Paritäten der genannten Kanalwörter (13) eines Ersatzcodes des genannten Modulationscodes.

4. Verfahren nach Anspruch 3, **gekennzeichnet durch** den genannten Ersatzcode, der zwei mögliche Kanalwörter mit entgegengesetzter Parität und einem gleichen Zustand in einer unterliegenden Endzustandsmaschine schafft.

5. Verfahren nach Anspruch 3, **gekennzeichnet durch** Codierung der genannten Fehlerkorrekturcodewörter (4) zu Kanalwörtern (13) mit
a) einem Hauptcode des genannten Modulationscodes,
b) dem genannten Ersatzcode des genannten Modulationscodes, oder
c) wobei der genannte Ersatzcode des genannten Modulationscodes ein Burst-Indikatorsubcodebit hat, codiert in den genannten Paritäten der genannten Kanalwörter (13).

6. Verfahren nach Anspruch 1, **gekennzeichnet durch** Streuung der Burst-Indikatorsubcodebits einer Anzahl Burst-Indikatorsubcodebytes über ein ganzes Frame (22) von Kanalwörtern (13).

7. Verfahren nach Anspruch 5 oder 6, **dadurch gekennzeichnet, dass** das genannte Frame (22) eine Anzahl Segmente (25) aufweist, wobei jedes Segment (25) eine Anzahl Bytes mit der nachfolgenden Struktur aufweist:
x₁B 1S x₂B 1S x₃B 1S....xₙ₋₁B 1S xₙB 1S xₙ₊₁B
unter der Bedingung, dass x₁, x₂, x₃,...,xₙ₋₁, xₙ, xₙ₊₁ ganze Werte sind und dass 2ₓ₁, x₂, ...,xₙ₋₁, xₙ, 2ₓₙ₊₁ möglichst nahe beieinander liegen und wobei B ein Byte bezeichnet, codiert mit dem genannten Hauptcode oder Ersatzcode ohne ein Burst-Indikatorsubcodebit und wobei S ein Byte bezeichnet, codiert mit dem genannten Ersatzcode mit einem Burst-Indikatorsubcodebit.

8. Verfahren nach Anspruch 7, **dadurch gekennzeichnet, dass** x₁₊ᵢ gleich 3 ist, dass x₂₊ᵢ gleich 5 ist und dass x₃₊ᵢ gleich 5 ist und dass x₄₊ᵢ gleich 3 ist, wobei i der Index der Segmente ist wobei i = 0,1,2,3,....,7 ist, wobei die Anzahl Bytes jede Segmentes 19 ist, wobei jedes Segment 3 Burst-Indikatorsubcodebits enthalten und jedes Frame 24 Burst-Indikatorsubcodebits oder 3 Burst-Indikatorsubcodebytes enthalten.

9. Verfahren nach Anspruch 1, **dadurch gekennzeichnet, dass** der genannte Modulationscode ein Code variabler Länge ist.

10. Verfahren nach Anspruch 9, **dadurch gekennzeichnet, dass** der genannte Code variabler Länge ein (1,7) lauflängenbegrenzter Paritätsbewahrcode ist.

11. Verfahren zum Decodieren von Informationswörtern (1), das die nachfolgenden Verfahrensschritte umfasst
- Decodieren eines Modulationscodes mit Kanalwörtern (13) zum Erreichen von Fehlerkorrekturcodewörtern (4) eines Fehlerkorrekturcodes,
- Decodieren der genannten Fehlerkorrekturcodewörter (4) zum Erreichen der genannten Information (1),
wobei ein Burst-Indikatorsubcode (8, 21) verwendet wird um Burstfehler anzugeben, wobei der genannte Burst-Indikatorsubcode (8, 21) Burst-Indikatorsubcodebytes aufweist, die eine Anzahl Burst-Indikatorsubcodebits enthalten,
**gekennzeichnet durch**
- Decodierung der genannten Burst-Indikatorsubcodebits aus verschiedenen Kanalwörtern (13).

12. Verfahren nach Anspruch 11, **gekennzeichnet durch** Decodierung der genannten Burst-Indikatorbits aus den Paritäten der genannten Kanalwörtern (13).

13. Verfahren nach Anspruch 11 oder 12, **gekennzeichnet durch** Zuordnung von Löschungen für die Fehlerkorrekturcodedecodierung auf Basis detektierter fehlerhafter Burst-Indikatorsubcodebits zum Korrigieren von Burstfehlern.

14. Verfahren nach Anspruch 11, 12 oder 13, **gekennzeichnet durch** Decodierung von Information, die nach einem der Ansprüche 1 bis 10 codiert wird.

15. Verfahren nach Anspruch 11, wobei eine Löschstrategie auf Fenstergröße w aufeinander folgender Burst-Indikatorsubcodebits basiert ist, wobei die Löschung zugeordnet wird, wenn und unter der Bedingung dass zwei aufeinander folgender Burst-Indikatorsubcodebits nicht mehr als um w-2 Stellen voneinander entfernt sind.

16. Anordnung zum Codieren von Informationswörtern (1), wobei diese Anordnung die nachfolgenden Elemente umfasst:
- Informationscodierungsmittel (3) zum Codieren von Informationswörtern zu einem Fehlerkorrekturcode mit Fehlerkorrekturcodewörtern (4),
- Codewortcodierungsmittel (12) zum Codieren von Fehlerkorrekturcodewörtern (4) zu einem Modulationscode mit Kanalwörtern (13),
- wobei ein Burst-Indikatorsubcode (8, 21) verwendet wird, der imstande ist, Burstfehler anzugeben, wobei der genannte Burst-Indikatorsubcode Burst-Indikatorsubcodebytes aufweist, die eine Anzahl Burst-Indikatorsubcodebits enthalten,
**dadurch gekennzeichnet, dass**
- die genannten Codewortcodierungsmittel (12) die genannten Burst-Indikatorsubcodebits jedes Burst-Indikatorsubcodebytes zu verschiedenen Kanalwörtern (13) codieren.

17. Anordnung zum Decodieren von Informationswörtern (1), wobei diese Anordnung die nachfolgenden Elemente aufweist:
- Codewortdecodierungsmittel (17) zum Decodieren eines Modulationscodes mit Kanalwörtern (16) zum Erreichen von Fehlerkorrekturcodewörtern (18) eines Fehlerkorrekturcodes,
- Informationsdecodierungsmittel (19) zum Decodieren der genannten Fehlerkorrekturcodewörter (18) zum Erreichen der genannten Information (1),
- wobei ein Burst-Indikatorsubcode (8, 21) verwendet wird um Burstfehler anzugeben, wobei der genannte Burst-Indikatorsubcode (8, 21) Burst-Indikatorsubcodebytes aufweist, die eine Anzahl Burst-Indikatorsubcodebits enthalten,
**dadurch gekennzeichnet, dass**
- die genannten Codewortdecodierungsmittel (17) die genannten Burst-Indikatorsubcodebits von verschiedenen Kanalwörtern (13) decodieren.

18. Speichermedium zum Speichern codierter Informationswörter (1), die entsprechend einem Verfahren nach einem der Ansprüche 1 bis 10 codiert worden sind.

19. Signal mit einem Strom von Kanalwörtern (13), die codierte Informationswörter (1) enthalten, die nach einem Verfahren nach einem der Ansprüche 1 bis 10 codiert worden sind.

## Revendications

1. Procédé permettant de coder des mots d'information (I) comprenant les étapes suivantes:
- le codage desdits mots d'information (1) en un code correcteur d'erreurs comprenant des mots de code correcteur d'erreurs (4);
- le codage desdits mots de code correcteur d'erreurs (4) en un code de modulation comprenant des mots de canal (13);
- en utilisant de ce fait un sous-code indicateur de paquet (8, 21) capable d'indiquer des paquets d'erreurs, ledit sous-code indicateur de paquet (8, 21) comprenant des octets de sous-code indicateur de paquet comportant un certain nombre de bits de sous-code indicateur de paquet;
**caractérisé par**:
- le codage desdits bits de sous-code indicateur de paquet de chaque octet de sous-code indicateur de paquet en mots de canal (13) différents.

2. Procédé suivant la revendication 1, **caractérisé par** le codage desdits bits de sous-code indicateur de paquet en une propriété caractéristique particulière de mots de canal différents, en particulier dans les parités desdits mots binaire (13) différents.

3. Procédé suivant la revendication 1 ou 2, **caractérisé par** le codage de chacun desdits bits de sous-code indicateur de paquet dans les parités desdits mots de canal (13) d'un code de substitution dudit code de modulation.

4. Procédé suivant la revendication 3, **caractérisé par le fait que** ledit code de substitution fournit deux mots de canal possibles ayant une parité opposée et un état suivant identique dans une machine à états finis sous-jacente.

5. Procédé suivant la revendication 3, **caractérisé par** le codage desdits mots de code correcteur d'erreurs (4) en mots de canal (13) avec
a) un code principal dudit code de modulation;
b) ledit code de substitution dudit code de modulation, ou
c) ledit code de substitution dudit code de modulation avec un bit de sous-code indicateur de paquet codé dans lesdites parités desdits mots de canal (13).

6. Procédé suivant la revendication 1, **caractérisé par** l'étalement des bits de sous-code indicateur de paquet d'un certain nombre d'octets de sous-code indicateur de paquet sur une trame (22) entière de mots de canal (13).

7. Procédé suivant la revendication 5 ou 6, **caractérisé en ce que** ladite trame (22) comprend un certain nombre de segments (25), chaque segment (25) comprenant un certain nombre d'octets présentant la structure
x₁B 1S x₂B 1S x₃B 1S... xₙ₋₁B 1S xₙB 1S Xₙ₊₁B
à condition que x₁, x₂, x₃, ..., xₙ₋₁, xₙ, xₙ₊₁ soient des valeurs entières et 2ₓ₁, x₂, ..., xₙ₋₁, xₙ, 2xₙ₊₁ soient aussi proches que possible les unes des autres, et où B indique un octet codé avec ledit code principal ou le code de substitution sans bit de sous-code indicateur de paquet et S indique un octet codé avec ledit code de substitution avec un bit de sous-code indicateur de paquet.

8. Procédé suivant la revendication 7, **caractérisé en ce que** x₁₊ᵢ est égal à 3, x₂₊ᵢ est égal à 5 et x₃₊ᵢ est égal à 5 et x₄₊ᵢ est égal à 3, i étant l'index des segments de sorte que i = 0, 1, 2, 3, ..., 7, le nombre d'octets de chaque segment est 19, chaque segment contenant 3 bits de sous-code indicateur de paquet et chaque trame contenant 24 bits de sous-code indicateur de paquet ou 3 octets de sous-code indicateur de paquet.

9. Procédé suivant la revendication 1, **caractérisé en ce que** ledit code de modulation est un code de longueur variable.

10. Procédé suivant la revendication 9, **caractérisé en ce que** ledit code de longueur variable est un code de préservation de parité RLL (1, 7).

11. Procédé permettant de décoder des mots d'information (1) comprenant les étapes suivantes:
- le décodage d'un code de modulation comprenant des mots de canal (13) afin d'obtenir des mots de code correcteur d'erreurs (4) d'un code correcteur d'erreurs;
- le décodage desdits mots de code correcteur d'erreurs (4) afin d'obtenir lesdites informations (1);
- en utilisant de ce fait un sous-code indicateur de paquet (8, 21) pour indiquer des paquets d'erreurs, ledit sous-code indicateur de paquet (8, 21) comprenant des octets de sous-code indicateur de paquet comportant un certain nombre de bits de sous-code indicateur de paquet;
**caractérisé par**:
- le décodage desdits bits de sous-code indicateur de paquet à partir de mots de canal (13) différents.

12. Procédé suivant la revendication 11, **caractérisé par** le décodage desdits bits indicateurs de paquet à partir des parités desdits mots de canal (13).

13. Procédé suivant la revendication 11 ou 12, **caractérisé par** l'attribution d'effacements pour le décodage par code correcteur d'erreurs sur la base de bits de sous-code indicateur de paquet erronés détectés afin de corriger les paquets d'erreurs.

14. Procédé suivant la revendication 11, 12 ou 13, **caractérisé par** le décodage d'informations codées suivant l'une quelconque des revendications 1 à 10.

15. Procédé suivant la revendication 11, dans lequel une stratégie d'effacement est basée sur une taille de fenêtre w de bits de sous-code indicateur de paquet successifs, en attribuant l'effacement si ou à condition que deux bits de sous-code indicateur de paquet erronés successifs ne soient pas éloignés de plus de w-2 emplacements l'un de l'autre.

16. Dispositif pour coder des mots d'information (1) comprenant:
- des moyens de codage d'informations (3) pour coder des mots d'information (1) en un code correcteur d'erreurs comprenant des mots de code correcteur d'erreurs (4);
- des moyens de codage de mots de codage (12) pour coder des mots de code correcteur d'erreurs (4) en un code de modulation comprenant des mots de canal (13);
- en utilisant de ce fait un sous-code indicateur de paquet (8, 21) capable d'indiquer des paquets d'erreurs, ledit sous-code indicateur de paquet comprenant des octets de sous-code indicateur de paquet comportant un certain nombre de bits de sous-code indicateur de paquet;
**caractérisé en ce que**
- lesdits moyens de codage de mots de code (12) codent lesdits bits de sous-code indicateur de paquet de chaque octet de sous-code indicateur de paquet en mots de canal (13) différents.

17. Dispositif pour décoder des mots d'information (1) comprenant:
- des moyens de décodage de mots de code (17) pour décoder un code de modulation comprenant des mots de canal (16) afin d'obtenir des mots de code correcteur d'erreurs (18) d'un code correcteur d'erreurs;
- des moyens de décodage d'informations (19) pour décoder lesdits mots de code correcteur d'erreurs (18) afin d'obtenir lesdites informations (1);
- en utilisant de ce fait un sous-code indicateur de paquet (8, 21) pour indiquer des paquets d'erreurs, ledit sous-code indicateur de paquet (8, 21) comprenant des octets de sous-code indicateur de paquet comportant un certain nombre de bits de sous-code indicateur de paquet;
**caractérisé en ce que**
- lesdits moyens de décodage de mots de code (17) décodent lesdits bits de sous-code indicateur de paquet à partir de mots de canal (13) différents.

18. Support de stockage sur lequel sont stockés des mots d'information (1) codés ayant été codés en fonction d'un procédé suivant l'une quelconque des revendications 1 à 10.

19. Signal comprenant un flux de mots de canal (13) contenant des mots d'information (1) codés ayant été codés en fonction d'un procédé suivant l'une quelconque des revendications 1 à 10.
